# FASCICULE DE BREVET EUROPEEN

(11) **EP 3 555 915 B1**
(45) Date de publication et mention de la délivrance du brevet: **27.01.2021**
(21) Numéro de dépôt: 17817809.1
(22) Date de dépôt: 06.12.2017
(51) Int. Cl.: H01L 23/538, H01L 23/473, H01L 25/11

(54) **CIRCUITS ÉLECTRONIQUES DE PUISSANCE EQUIPÉS DE BUS BARRES FORMANT DISSIPATEURS THERMIQUES ET PROCÉDÉ D'INTÉGRATION**
ELEKTRONISCHE LEISTUNGSSCHALTUNGEN MIT STROMSCHIENEN, DIE KÜHLKÖRPER BILDEN, UND INTEGRATIONSVERFAHREN
ELECTRONIC POWER CIRCUITS COMPRISING BUS-BARS FORMING HEAT SINKS AND INTEGRATION METHOD

(30) Priorité: 19.12.2016 FR 1662803
(43) Date de publication de la demande: 23.10.2019
(73) Titulaire: Institut VEDECOM, 78000 Versailles (FR); Elvia PCB, 50211 Coutances Cedex (FR)
(72) Inventeur: KIEL, Friedbald, 77300 Fontainebleau (FR); BELNOUE, Olivier, 45390 Ondreville-sur-Essonne (FR)
(74) Mandataire: Ménès, Catherine
(86) Numéro de dépôt international: PCT/FR2017/053407
(87) Numéro de publication internationale: WO 2018/115624

(56) Documents cités:
- US-A1- 2016 133 558

## Description

L'invention concerne de manière générale le domaine de l'électronique de puissance. Plus particulièrement, l'invention se rapporte à un circuit électronique de puissance équipé de bus barres formant dissipateurs thermiques. L'invention se rapporte également à un dispositif comportant plusieurs de ces circuits et à un procédé d'intégration de puces électroniques de puissance et d'interconnexion de bus barres pour la réalisation de ces circuits.

Les dispositifs électroniques de puissance, tels que les convertisseurs de puissance, sont très présents dans de nombreux domaines d'activité comme les transports, les industries, l'éclairage, le chauffage, etc. Avec la transition énergétique souhaitée vers des sources d'énergie renouvelables et moins productrices d'émissions de CO₂, l'électronique de puissance est appelée à se généraliser encore davantage et devra répondre à des contraintes économiques et technologiques croissantes.

Les recherches et développements actuels se concentrent sur la réduction des coûts, l'augmentation de la densité de puissance, l'augmentation de la fiabilité, la réduction des éléments parasites et le transfert thermique de l'énergie dissipée.

Dans l'état actuel de la technique, il est habituel de faire appel à la technologie dite HDI, de « High Density Interconnect » en anglais, pour augmenter le niveau d'intégration et réduire la taille des circuits de puissance. La technologie HDI implémentée généralement sur des circuits imprimés dit PCB, de « Printed Circuit Board » en anglais, est fondée sur une optimisation de l'implantation spatiale des composants en utilisant notamment des rubans et des plaques de céramiques portant un circuit de traces en cuivre, dit « lead frames », pour interconnecter des composants montés en surface ou, dans une technologie plus avancée, des micro-trous dits « microvias » remplis de cuivre pour interconnecter des composants encastrés. Il est utilisé le perçage par rayon laser ainsi que différentes techniques de soudure telles que par exemple le brasage, la soudure en phase liquide transitoire dite soudure TLP ou le frittage de poudre de nanoparticules métalliques.

La technologie HDI trouve cependant ses limites face aux réductions de coût qui sont nécessaires pour des productions de masse, et à l'augmentation du niveau d'intégration et de la compacité. Le niveau d'intégration qu'il est possible d'obtenir est limité par le volume occupé par les interconnexions avec rubans et microvias. Les interconnexions avec rubans ou câbles introduisent des inductances parasites qui s'opposent à des fréquences de découpage ou de commutation plus élevées. Or l'augmentation des fréquences de commutation est généralement favorable à la compacité, notamment dans les convertisseurs de puissance. La réduction des inductances parasites est nécessaire aussi pour réduire la chaleur générée, protéger les circuits par rapport à des surtensions potentiellement destructrices et améliorer la maîtrise des rayonnements électromagnétiques.

Un refroidissement performant est nécessaire pour maintenir les températures les composants actifs et passifs en dessous de valeurs critiques, pour atteindre un équilibre thermique et garantir la fiabilité des circuits de puissance. La disponibilité de puces en silicium ayant des surfaces de plus en plus réduites et les nouveaux semi-conducteurs de puissance, comme le carbure de silicium, autorisent des densités de courant supérieures et une augmentation de la fréquence de découpage, ce qui permet une compacité encore supérieure des circuits de puissance. Mais pour cela, l'architecture des circuits de puissance et la technologie utilisée doivent assurer une extraction de l'énergie dissipée au plus près des composants. Il est nécessaire d'optimiser le chemin thermique entre les sources de chaleur constituées des composants et les puits de chaleur constitués des moyens de dissipation thermique.

Dans les technologies connues, la chaleur doit traverser différentes couches comme la soudure, le substrat diélectrique plaqué de cuivre, la plaque métallique de base, le matériau d'interface thermique et la masse du dissipateur de chaleur, avant d'être transférée dans l'air ou dans un liquide de refroidissement.

Il apparaît aujourd'hui nécessaire de proposer une technologie nouvelle pour la fabrication de dispositifs électroniques de puissance ayant des performances supérieures de dissipation thermique et autorisant une meilleure optimisation par rapport aux différentes contraintes qui s'appliquent.

Selon un premier aspect, l'invention concerne un circuit électronique conforme à l'enseignement de de la demande de brevet US 2016/133558 et comprenant ainsi un circuit électroniquede puissance comprenant au moins une puce électronique (MT, MD), un substrat stratifié (LA1, LA2, SB) formé de couches isolantes et conductrices et des moyens de dissipation thermique, ladite puce électronique étant implantée dans ledit substrat et lesdits moyens de dissipation thermique étant fixés sur des première et deuxième faces opposées dudit substrat, lesdits moyens de dissipation thermique comprenant des premier et deuxième bus barres formant dissipateurs thermiques (BBH, BBL) et montés respectivement sur lesdites première et deuxième faces opposées dudit substrat. Conformément à l'invention lesdits premier et deuxième bus barres (BBH, BBL) sont formés chacun d'une pluralité de tronçons de bus barre en métal (BB1H, BB2H, BB3H, BB4H ; BB1L, BB2L, BB3L) fixés à des emplacements espacés prédéterminés (MCH, PE, MCL) et interconnectés entre eux et avec une face de contact de ladite puce électronique (MT, MD) par une couche de métal (MEH, MEL).

Selon une caractéristique particulière du circuit de l'invention, les tronçons de bus barre sont fixés aux première et deuxième faces opposées du substrat à travers des couches diélectriques.

Selon une autre caractéristique particulière, au moins un des tronçons de bus barre est fixé sur une électrode de la puce à travers une couche diélectrique.

Selon encore une autre caractéristique particulière, les tronçons de bus barre et les couches conductrices et couches de métal du circuit sont en cuivre.

Selon un autre aspect, l'invention concerne aussi un dispositif électronique de puissance comprenant au moins deux circuits tels que décrits brièvement ci-dessus, un premier circuit dit haut étant empilé sur un deuxième circuit dit bas, les circuits haut et bas étant liés mécaniquement et électriquement par leurs bus barres respectifs, et comprenant au moins un espace central de circulation de liquide de refroidissement qui est situé entre les circuits haut et bas, l'espace central de circulation de liquide de refroidissement étant formé entre des tronçons des bus barres.

Selon une caractéristique particulière, le dispositif comprend également au moins un espace haut de circulation de liquide de refroidissement qui est situé dans une partie haute du dispositif, l'espace haut de circulation de liquide de refroidissement étant formé entre des tronçons d'un bus barre haut du circuit haut et une couche diélectrique haute.

Selon une autre caractéristique particulière, le dispositif comprend également au moins un espace bas de circulation de liquide de refroidissement qui est situé dans une partie basse du dispositif, l'espace bas de circulation de liquide de refroidissement étant formé entre des tronçons d'un bus barre bas du circuit bas et une couche diélectrique basse.

Selon une autre caractéristique particulière, le dispositif comprend au moins un circuit de commande fixé sur une partie haute ou une partie basse du dispositif à travers une couche diélectrique.

Selon encore un autre aspect, l'invention concerne aussi un procédé d'intégration de puces électroniques de puissance et de bus barres formant dissipateurs thermiques pour la réalisation d'un circuit électronique de puissance tel que décrit brièvement plus haut. Conformément à l'invention, le procédé comprend :
- une réalisation d'une ébauche intégrant au moins une puce électronique comprise entre des couches internes stratifiées isolantes et/ou conductrices ;
- une fixation mécanique, par l'intermédiaire de portions diélectriques de préimprégné de résine, de tronçons de bus barre en métal à des emplacements espacés prédéterminés sur des faces opposées haute et basse de l'ébauche ; et
- pour chacune des faces opposées haute et basse, une interconnexion par dépôt de couche de métal des tronçons de bus barre fixés sur la face considérée et d'une face de contact de la puce électronique, formant ainsi le circuit électronique de puissance comportant des bus barres formant dissipateurs thermiques.

Selon une caractéristique particulière, le procédé comporte des étapes de stratification, de retrait de matière par ablation, d'électrodéposition et de photolithographie.

D'autres avantages et caractéristiques de la présente invention apparaîtront plus clairement à la lecture de la description détaillée ci-dessous de plusieurs formes de réalisation particulières de l'invention, en référence aux dessins annexés, dans lesquels :
les Figs.1 à 15 sont des vues en coupe simplifiées montrant des étapes du procédé d'intégration de puces électroniques de puissance et de bus barres formant dissipateurs thermiques selon l'invention ; et
la Fig.16 est une vue en coupe simplifiée montrant une forme de réalisation particulière d'un dispositif électronique de puissance selon l'invention, avec un refroidissement liquide.

Un mode de réalisation particulier du procédé selon l'invention est maintenant décrit ci-dessus dans le cadre de la réalisation d'un dispositif ou module électronique de puissance sous la forme d'une branche de pont, ou demi-pont, de commutation à transistors. De manière classique, la branche de pont comprend un transistor haut et un transistor bas, dits respectivement «low side» et «high side» en anglais, et des diodes associées. De tels dispositifs peuvent être associés pour former des ponts complets de commutation ou associés en parallèle pour passer le courant voulu.

De manière générale, il est utilisé dans l'invention des techniques de fabrication connues et bien maîtrisées des circuits imprimés pour l'intégration des puces électroniques. Ainsi, il pourra être fait appel dans le procédé selon l'invention à une combinaison de différentes techniques de fabrication comprenant la stratification, l'ablation laser, la photolithographie, le dépôt électrolytique de métal et la gravure humide. Le dépôt électrolytique de métal pourra notamment être utilisé pour l'interconnexion des puces électroniques et des bus barres.

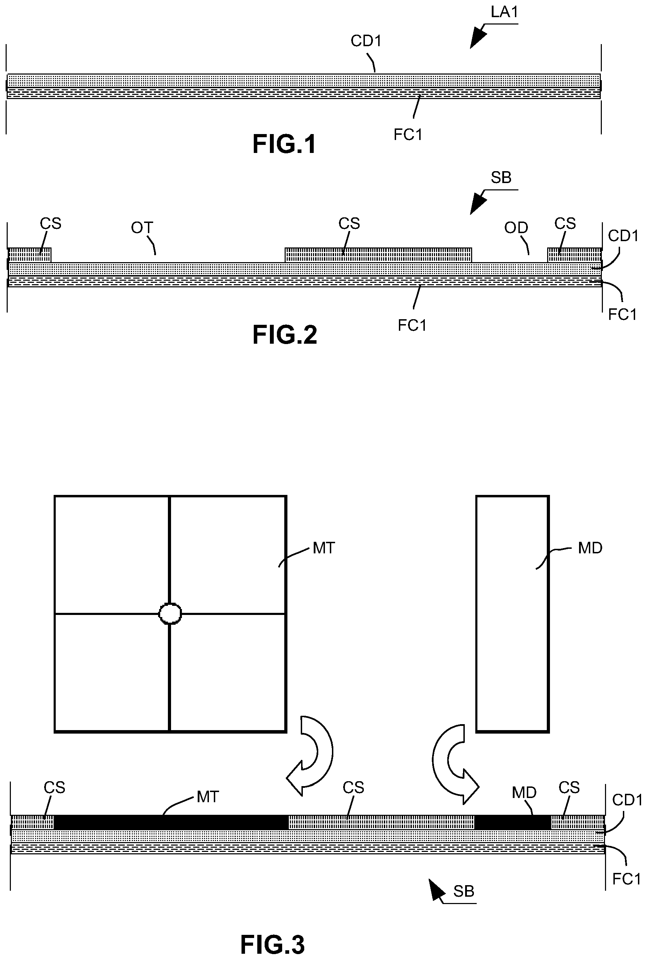

En référence aux Figs.1 à 15, il est maintenant décrit en détail différentes étapes de fabrication intervenant dans le procédé d'intégration de puces électroniques de puissance et d'interconnexion de bus barres selon l'invention.

Les Figs.1 et 2 montrent une étape initiale de fabrication d'un substrat de base SB comprenant des cavités pour recevoir des puces électroniques.

Le substrat SB est réalisé à partir d'un stratifié, dit également laminé, LA1 sur lequel sont déposées des portions diélectriques CS.

Le stratifié LA1 est formé d'une couche diélectrique CD1 qui est fixée sur une feuille métallique conductrice FC1 typiquement en cuivre. La couche CD1 est typiquement une couche diélectrique de stade B, c'est-à-dire à un stade intermédiaire de polymérisation, composée de fibres de verre et d'une résine de type époxy. En variante, un stratifié organique ou stratifié revêtu de cuivre dit CCL (de «Copper Clad Laminate» en anglais) pourra également être utilisé.

Les portions diélectriques CS sont découpées préalablement et reportées sur la couche diélectrique CD1 pour former des cavités OT et OD. Les portions diélectriques CS sont formées typiquement d'une couche diélectrique de stade C, c'est-à-dire complètement polymérisée, composée de fibres de verre et d'une résine de type époxy.

A l'étape de la Fig.3, des puces de composants, par exemple, sous la forme d'un transistor de puissance MT et d'une diode MD, sont mises en place dans les cavités OT et OD du substrat SB.

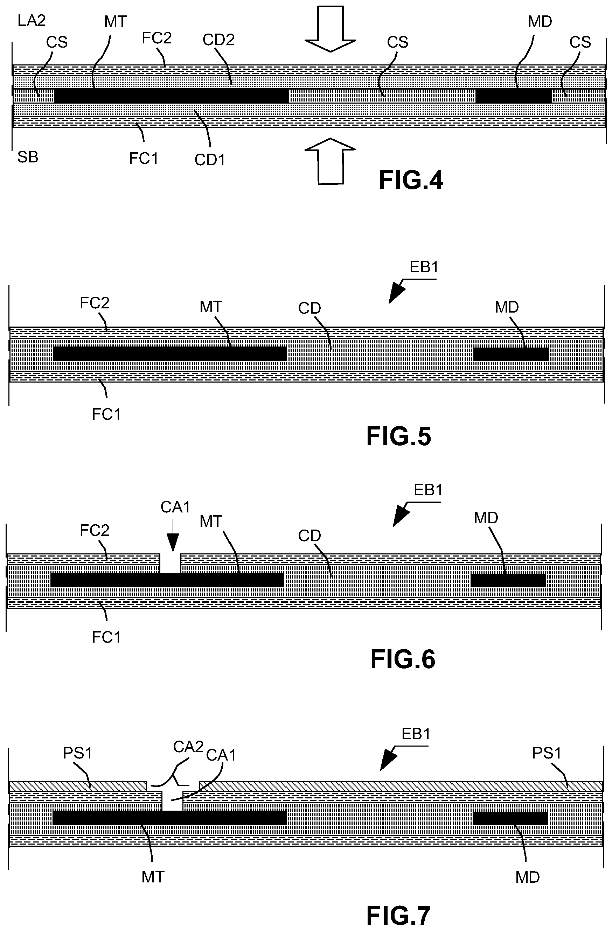

L'étape de la Fig.4 montre le placage sur le substrat SB, portant les puces MT et MD, d'un autre stratifié LA2, analogue au stratifié LA1 de la Fig.1. Le stratifié FA2 comporte une feuille métallique conductrice FC2, en cuivre, et une couche diélectrique CD2.

A ce stade, les couches diélectriques CD1 et CD2 ne sont encore que partiellement polymérisées. Les puces MT et MD sont prises en sandwich entre les couches diélectriques CD1 et CD2. La stratification de LA2 sur le substrat SB est typiquement obtenue par pressage et passage au four de stratification sous vide.

En sortie du four de stratification sous vide, à la Fig.5, il est obtenu une ébauche EB1 dans laquelle les puces MT et MD sont enterrées dans une couche diélectrique CD, totalement polymérisée et provenant de la stratification des couches CD1, CS et CD2. Les feuilles de cuivre FC1 et FC2 constituent des faces opposées basse et haute de l'ébauche EB1.

A l'étape de la Fig.6, des opérations de retrait de matière, par exemple par ablation laser, sont effectuées sur l'ébauche EB1 dans le but de réaliser des motifs métalliques fins de connexion des puces. Comme montré à la Fig.6, une cavité CA1 est ici réalisée sur la face haute de l'ébauche EB1 de manière à dégager une électrode de commande de la puce MT. La puce MT est par exemple ici un transistor de puissance de type MOSFET et l'électrode de commande qui est dégagée est l'électrode de grille du transistor.

L'étape de la Fig.7 montre une résine photorésist de masquage PS1 qui a été enduite sur la face haute de l'ébauche EB1. Une partie CA2 de la résine a été dégagée de manière classique en faisant appel à un masque de sérigraphie et une exposition à un rayonnement ultraviolet. Les espaces dégagés CA1 et CA2 sont destinés à la réalisation d'un plot de contact et d'un recouvrement de connexion sur ruban pour l'électrode de commande de la puce MT.

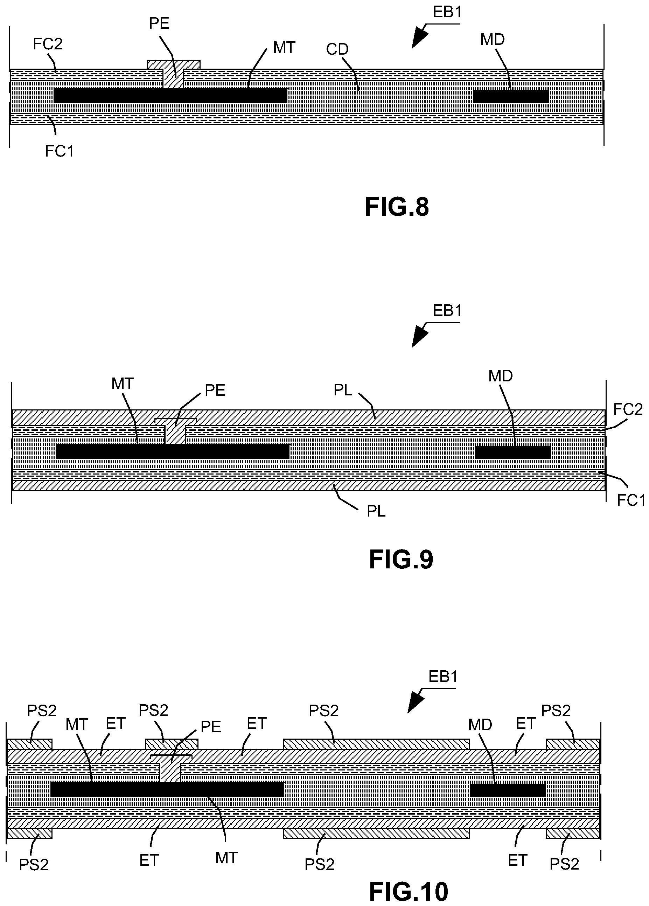

La Fig.8 montre, à un stade intermédiaire de réalisation, le plot de contact PE de l'électrode de commande de la puce MT, après retrait de la résine de masquage PS1 par une méthode connue telle que par exemple un traitement par plasma d'oxygène, un décapage par voie sèche ou au solvant. Le plot de contact PE est réalisé sur l'ébauche EB1 par dépôt électrolytique de métal, typiquement du cuivre, dans les espaces dégagés CA1 et CA2 montrés à la Fig.7.

A l'étape de la Fig.9, il est effectué un dépôt électrolytique de cuivre qui est destiné à planariser les faces haute et basse de l'ébauche EB1. La face haute de l'ébauche EB1, formée de la feuille en cuivre FC2 et du plot de contact d'électrode PE est recouverte d'une couche de cuivre de planarisation PL. La face basse de l'ébauche EB1, formée de la feuille en cuivre FC1, est également recouverte d'une couche de cuivre de planarisation PL.

L'étape 10 est une autre étape de photolithographie pour achever la définition des motifs métalliques fins de connexion sur les faces haute et basse de l'ébauche EB1. Comme montré à la Fig.10, une résine photorésist PS2 a été déposée sur les faces haute et basse de l'ébauche EB1. Des portions métalliques ET à retirer par gravure humide ont ensuite été définies et la résine PS2 a été enlevée de ces portions.

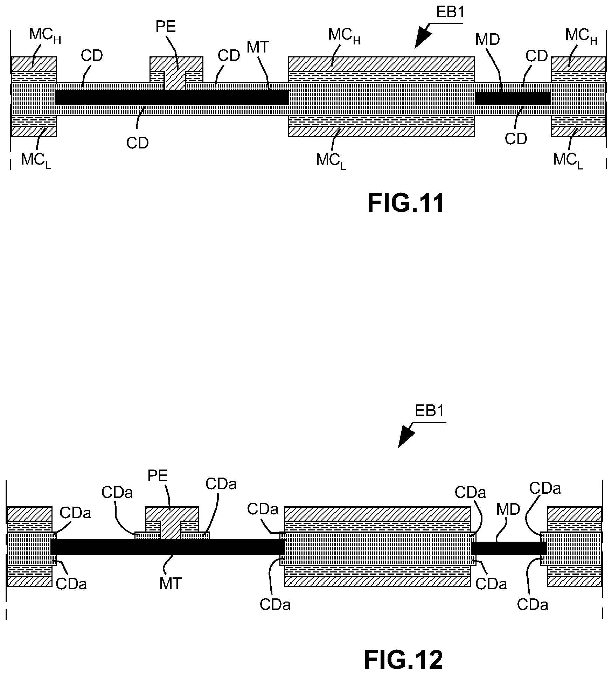

L'ébauche EB1 après la gravure de l'étape 10 est montrée à la Fig.11. Comme montré à la Fig.11, le retrait par gravure des parties de cuivre exposées laissent apparaître des portions de la couche diélectrique CD sous-jacente. A ce stade, les motifs métalliques de connexion hauts et bas MC_{H}, PE et MC_{L} de l'ébauche EB1 sont achevés et définis avec précision, notamment le plot de contact d'électrode PE et son ruban de connexion (non apparent). Il reste cependant à dégager des faces de contact hautes et basses des puces MT et MD enterrées dans la couche diélectrique sous-jacente CD.

A l'étape de la Fig.12, les faces de contact hautes et basses des puces MT et MD ont été dégagées par retrait de matière, par exemple par ablation laser. Comme cela apparaît à la Fig.12, des portions diélectriques CDa, provenant de la couche CD, ont été laissées de part et d'autre des motifs métalliques de connexion et notamment du plot de contact d'électrode PE et de son ruban de connexion.

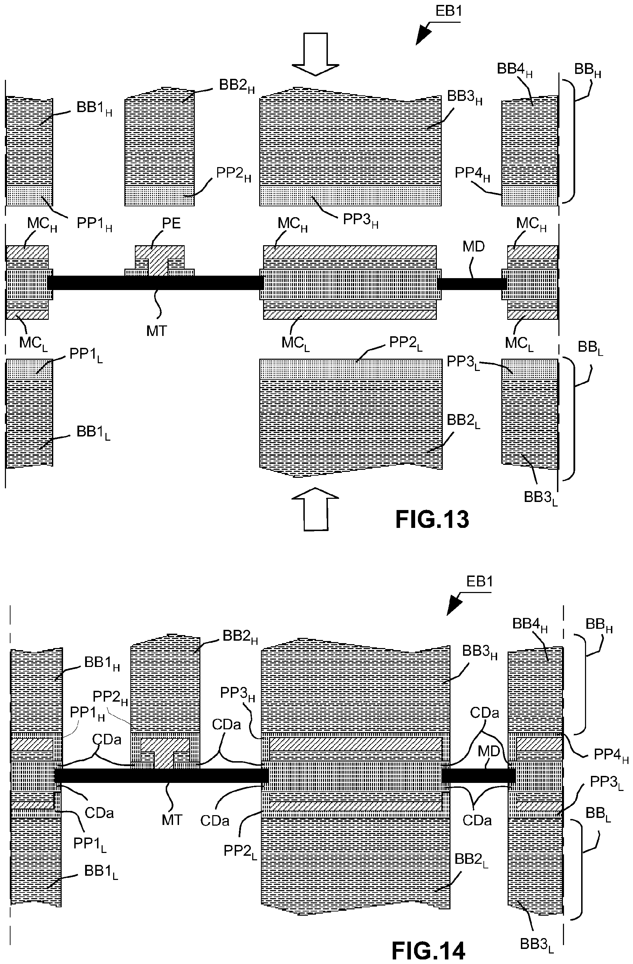

Les Figs.13 à 15 montrent l'interconnexion de bus barres haut BB_{H} et bas BB_{L} sur les faces opposées haute et basse de l'ébauche EB1. Outre leurs fonctions électriques habituelles d'alimentation électrique ou autres, les bus barres haut BB_{H} et bas BB_{L} sont ici destinés à former des dissipateurs thermiques implantés sur les faces opposées haute et basse de l'ébauche EB1. Les bus barres BB_{H}, BB_{L} sont typiquement en cuivre.

Comme montré à la Fig.13, les bus barres BB_{H} et bas BB_{L} sont formés chacun de plusieurs tronçons de bus BB1_{H}, BB2_{H}, BB3_{H}, BB4_{H} et BB1_{L}, BB2_{L}, BB3_{L} qui ont été préalablement découpés, par exemple, par usinage mécanique, ou éventuellement obtenus par moulage.

Des portions diélectriques de préimprégné de stade B, PP1_{H}, PP2_{H}, PP3_{H}, PP4_{H}, sont reportées sur des faces correspondantes des tronçons de bus BB1_{H}, BB2_{H}, BB3_{H}, BB4_{H} destinées à être plaquées sur la face haute de l'ébauche EB1. Des portions diélectriques de préimprégné de stade B, PP1_{L}, PP2_{L}, PP3_{L}, sont reportées sur des faces correspondantes des tronçons de bus BB1_{L}, BB2_{L}, BB3_{L} destinées à être plaquées sur la face basse de l'ébauche EB1. Les portions diélectriques PP1_{H}, PP2_{H}, PP3_{H}, PP4_{H} et PP1_{L}, PP2_{L}, PP3_{L} sont prévues pour être plaquées sur les portions de motifs métalliques de connexion MC_{H}, PE et MC_{L} de l'ébauche EB1 et recouvrir ceux-ci.

L'ébauche EB1 est ainsi prise en sandwich entre les tronçons de bus BB1_{H}, BB2_{H}, BB3_{H}, BB4_{H} et BB1_{L}, BB2_{L}, BB3_{L}. Les tronçons de bus BB1_{H}, BB2_{H}, BB3_{H}, BB4_{H} et BB1_{L}, BB2_{L}, BB3_{L} sont pressés, avec les portions diélectriques PP1_{H}, PP2_{H}, PP3_{H}, PP4_{H} et PP1_{L}, PP2_{L}, PP3_{L}, contre les faces haute et basse de l'ébauche EB1 et, plus précisément, contre les motifs métalliques de connexion MC_{H}, PE et MC_{L} de celle-ci. La stratification de l'ensemble est typiquement obtenue par pressage sous vide ou passage au four de stratification sous vide.

La Fig.14 montre l'état de l'ébauche EB1 avec les tronçons de bus assemblés. A ce stade, les tronçons de bus sont fixés mécaniquement au circuit par la polymérisation complète des portions diélectriques. Les motifs diélectriques d'isolation du circuit sont finalisés à ce stade. On notera ici que les portions diélectriques PP1_{H}, PP2_{H}, PP3_{H}, PP4_{H} et PP1_{L}, PP2_{L}, PP3_{L}, après pressage et polymérisation, se sont solidarisées avec les portions diélectriques CDa et isolent électriquement les motifs métalliques de connexion MCH, PE et MCL par rapport aux bus barres. L'épaisseur des portions diélectriques PP1_{H}, PP2_{H}, PP3_{H}, PP4_{H} et PP1_{L}, PP2_{L}, PP3_{L}, est choisie de manière à assurer des performances d'isolation électrique et de conductivité thermique adaptées.

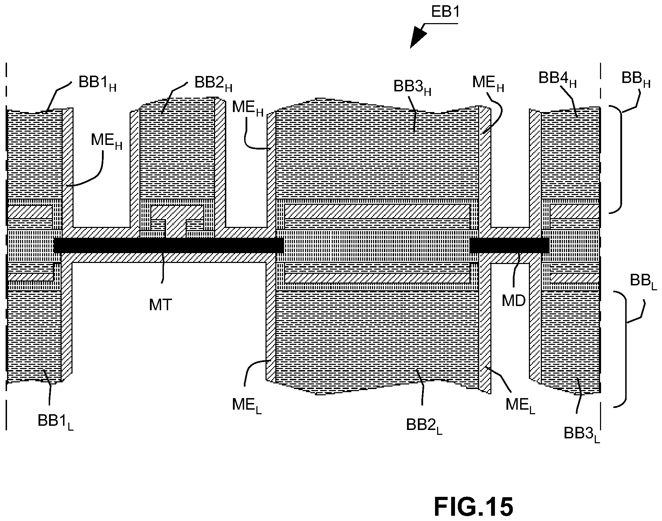

L'étape de la Fig.15 est une étape de métallisation et soudure qui permet de finaliser, d'une part, l'assemblage mécanique et, d'autre part, l'interconnexion électrique des tronçons hauts de bus BB1_{H}, BB2_{H}, BB3_{H}, BB4_{H} et des faces hautes de contact des puces MT, MD, et l'interconnexion électrique des tronçons bas de bus BB1_{L}, BB2_{L}, BB3_{L} et des faces basses de contact des puces MT, MD.

On notera ici que le tronçon de bus barre BB2_{H} fixé au-dessus du plot de contact d'électrode PE et de son ruban de connexion a pour fonction de refroidir efficacement l'électrode de commande de la puce MT.

Comme montré à la Fig.15, des couches de cuivre ME_{H} et ME_{L} sont déposées par électrodéposition sur les parties haute et basse de l'ébauche EB1.

La couche de cuivre ME_{H} est déposée sur la partie haute de l'ébauche EB1 est interconnecte les tronçons de bus BB1_{H}, BB2_{H}, BB3_{H} et BB4_{H} du bus barre BB_{H} et les faces hautes des puces de transistor MT et de diode MD qui correspondent, par exemple, à des électrodes de drain et de cathode. La couche de cuivre ME_{L} est déposée sur la partie basse de l'ébauche EB1 et interconnecte les tronçons de bus BB1_{L}, BB2_{L} et BB3_{L} du bus barre BB_{L} et les faces basses des puces de transistor MT et de diode MD qui correspondent à des électrodes de source et d'anode.

Le procédé selon l'invention, tel que décrit plus haut en référence aux Figs.1 à 15, autorise la fabrication de briques élémentaires de circuit qui peuvent être assemblées pour constituer des dispositifs électroniques de puissance de complexité plus ou moins grande, avec une architecture en sandwich. L'assemblage des briques élémentaires est typiquement réalisé sous presse et passage au four. Les liaisons mécaniques et électriques entre les deux briques sont faites par soudure. On notera qu'une parallélisation de la fabrication est possible en produisant les briques élémentaires de circuit sur plusieurs lignes de fabrication.

L'architecture des briques élémentaires de circuit selon l'invention permet un contact en cuivre direct entre les dissipateurs thermiques, formés des bus barres, et les faces de contact hautes et basses des puces électroniques. Les dissipateurs thermiques constitués de masses de cuivre situées de part et d'autre des puces électroniques et en contact direct avec celles-ci autorise une extraction efficace des calories. Le refroidissement des électrodes de commande des puces de transistor est également optimisé grâce à des tronçons de bus barres plaqués contre elles. De plus, les longueurs des conducteurs de connexion sont minimisées, ce qui favorise la réduction des inductances parasites et davantage de compacité.

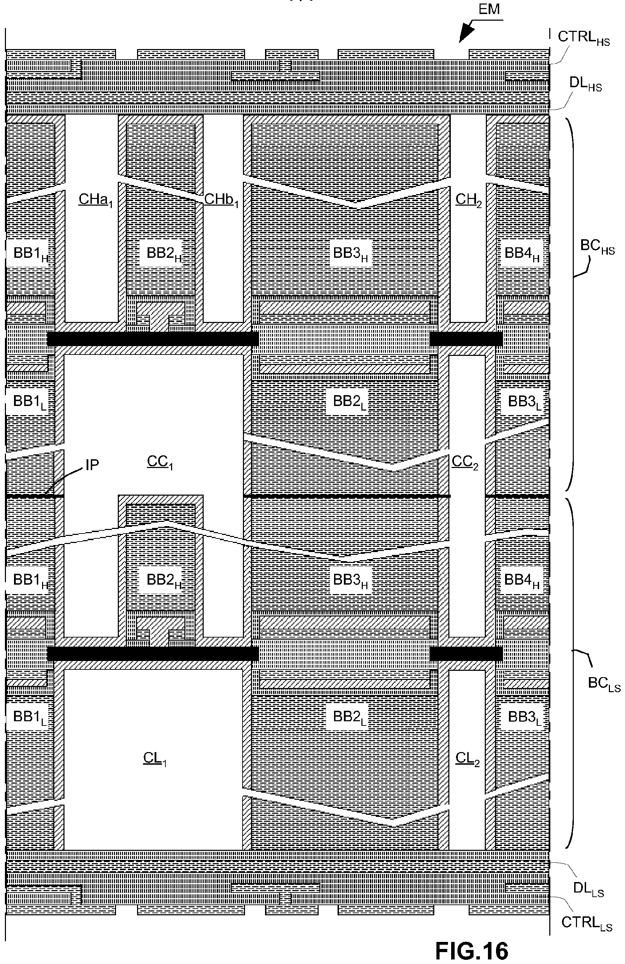

La Fig.16 montre un dispositif électronique de puissance à refroidissement liquide EM qui est construit par empilement de deux briques élémentaires de circuit BC_{HS} et BC_{LS}. Le dispositif EM est ici une branche de pont de transistors composée de deux transistors MOSFET et deux diodes de roue libre.

La liaison mécanique et électrique des deux briques élémentaires empilées BC_{HS} et BC_{LS} est réalisée au niveau d'un plan de jonction IP par assemblage entre eux des bus barres BB_{H} et BB_{L}, par leurs tronçons BB1_{L}, BB2_{L}, BB3_{L} et BB1_{H}, BB3_{H}, BB4_{H}. L'assemblage pourra être fait, par exemple, par une soudure à phase liquide transitoire dite TLP ou d'autres techniques de soudure.

L'assemblage des briques élémentaires BB_{HS} et BB_{LS} crée en partie centrale du dispositif des espaces centraux de circulation de liquide de refroidissement, ici CC₁ et CC₂. Ces espaces de circulation de liquide de refroidissement CC₁ et CC₂, situés au plus près des puces électroniques, sont prévus pour la circulation sous pression d'un liquide de refroidissement caloporteur.

Le dispositif EM comporte des circuits de commande CTRL_{HS} et CTRL_{LS} qui sont intégrés en parties haute et basse du dispositif EM, respectivement. Les circuits de commande CTRL_{HS} et CTRL_{LS} sont fixés mécaniquement et isolés électriquement des parties haute et basse des briques élémentaires BC_{HS} et BC_{LS} par des couches diélectriques DL_{HS} et DL_{LS}, respectivement. Les circuits CTRL_{HS} et CTRL_{LS} comportent chacun plusieurs couches stratifiées, réalisées selon des techniques connues. Des composants actifs et passifs pourront si nécessaire être enfouis entre les couches internes des circuits CTRL_{HS} et CTRL_{LS}, ou bien implantés en surface sur le circuit de manière classique par brasure ou colle conductrice.

Comme cela apparaît à la Fig.16, l'intégration en partie haute et basse du dispositif EM des circuits de commande CTRL_{HS} et CTRL_{LS} avec les couches diélectriques isolantes DL_{HS} et DL_{LS} permet la formation d'espaces haut et bas de circulation de liquide de refroidissement CHa₁, CHb₁, CH₂ et CL₁, CL₂. Ces espaces CHa₁, CHb₁, CH₂ et CL₁, CL₂ situés de part et d'autre des espaces centraux CC₁ et CC₂ autorisent un refroidissement accru du dispositif EM. Les puces électroniques sont ainsi refroidies de manière plus efficace par la circulation d'un liquide caloporteur à proximité de leurs faces haute et basse et des électrodes de commande.

D'autres formes de réalisation de dispositifs électroniques de puissance selon l'invention sont bien entendu possibles. Ainsi, par exemple, la partie haute et/ou la partie basse du dispositif EM pourrait être fermée avec simplement une couche diélectrique, sans pour autant implanter un circuit de commande à cet emplacement. Ou bien, la partie basse du dispositif EM pourrait rester ouverte, pour un refroidissement à air, le profil en créneau du bus barre apportant un accroissement de la surface d'échange thermique.

L'invention ne se limite pas aux formes de réalisation particulières qui ont été décrites ici à titre d'exemple. L'homme du métier, selon les applications de l'invention, pourra apporter différentes modifications et variantes qui entrent dans la portée des revendications ci-annexées.

## Revendications

1. Circuit électronique de puissance comprenant au moins une puce électronique (MT, MD), un substrat stratifié (LA1, LA2, SB) formé de couches isolantes et conductrices et des moyens de dissipation thermique, ladite puce électronique étant implantée dans ledit substrat et lesdits moyens de dissipation thermique étant fixés sur des première et deuxième faces opposées dudit substrat, lesdits moyens de dissipation thermique comprenant des premier et deuxième bus barres formant dissipateurs thermiques (BBH, BBL) et montés respectivement sur lesdites première et deuxième faces opposées dudit substrat, **caractérisé en ce que** lesdits premier et deuxième bus barres (BBH, BBL) sont formés chacun d'une pluralité de tronçons de bus barre en métal (BB1H, BB2H, BB3H, BB4H ; BB1L, BB2L, BB3L) fixés à des emplacements espacés prédéterminés (MCH, PE, MCL) et interconnectés entre eux et avec une face de contact de ladite puce électronique (MT, MD) par une couche de métal (MEH, MEL).

2. Circuit électronique de puissance selon la revendication 1, **caractérisé en ce que** lesdits tronçons de bus barre (BB1_{H}, BB2_{H}, BB3_{H}, BB4_{H} ; BB1_{L}, BB2_{L}, BB3_{L}) sont fixés auxdites première et deuxième faces opposées dudit substrat à travers des couches diélectriques (PP1_{H}, PP2_{H}, PP3_{H}, PP4_{H} ; PP1_{L}, PP2_{L}, PP3_{L}).

3. Circuit électronique de puissance selon la revendication 1 ou 2, **caractérisé en ce qu'**au moins un (BB2_{H}) desdits tronçons de bus barre est fixé sur une électrode (PE) de ladite puce (MT) à travers une couche diélectrique (PP2_{H}).

4. Circuit électronique de puissance selon l'une quelconque des revendications 1 à 3, **caractérisé en ce que** lesdits tronçons de bus barre (BB1_{H}, BB2_{H}, BB3_{H}, BB4_{H} ; BB1_{L}, BB2_{L}, BB3_{L}) et lesdites couches conductrices (FC1, FC2, PL) et couches de métal (ME_{H}, ME_{L}) sont en cuivre.

5. Dispositif électronique de puissance, **caractérisé en ce qu'**il comprend au moins deux circuits selon l'une quelconque des revendications 1 à 4, un premier circuit dit haut (BC_{HS}) étant empilé sur un deuxième circuit dit bas (BC_{LS}), lesdits circuits haut et bas (BC_{HS}, BC_{LS}) étant liés mécaniquement et électriquement par leurs bus barres respectifs (BB_{H}, BB_{L}), et **en ce qu'**il comprend au moins un espace central de circulation de liquide de refroidissement (CC₁, CC₂) qui est situé entre lesdits circuits haut et bas (BC_{HS}, BC_{LS}), ledit espace central de circulation de liquide de refroidissement (CC₁, CC₂) étant formé entre des tronçons (BB1_{H}, BB2_{H}, BB3_{H}, BB4_{H} ; BB1_{L}, BB2_{L}, BB3_{L}) desdits bus barres (BB_{H}, BB_{L}).

6. Dispositif électronique de puissance selon la revendication 5, **caractérisé en ce qu'**il comprend également au moins un espace haut de circulation de liquide de refroidissement (CHa₁, CHb₁, CH₂) qui est situé dans une partie haute du dispositif (EM), ledit espace haut de circulation de liquide de refroidissement (CHa₁, CHb₁, CH₂) étant formé entre des tronçons (BB1_{H}, BB2_{H}, BB3_{H}, BB4_{H}) d'un bus barre haut (BB_{H}) dudit circuit haut (BC_{HS}) et une couche diélectrique haute (DL_{HS}).

7. Dispositif électronique de puissance selon la revendication 5 ou 6, **caractérisé en ce qu'**il comprend également au moins un espace bas de circulation de liquide de refroidissement (CL₁, CL₂) qui est situé dans une partie basse du dispositif (EM), ledit espace bas de circulation de liquide de refroidissement (CL₁, CL₂) étant formé entre des tronçons (BB1_{L}, BB2_{L}, BB3_{L}) d'un bus barre bas (BB_{L}) dudit circuit bas (BC_{LS}) et une couche diélectrique basse (DL_{LS}).

8. Dispositif électronique de puissance selon l'une quelconque des revendications 5 à 7, **caractérisé en ce qu'**il comprend au moins un circuit de commande (CTRL_{HS}, CTRL_{LS}) fixé sur une partie haute ou une partie basse du dispositif (EM) à travers une couche diélectrique (DL_{HS}, DL_{LS}).

9. Procédé d'intégration de puces électroniques de puissance et de bus barres formant dissipateurs thermiques pour la réalisation d'un circuit électronique de puissance selon l'une quelconque des revendications 1 à 4, **caractérisé en ce qu'**il comprend :
- une réalisation d'une ébauche (EB1) intégrant au moins une puce électronique (MT, MD) comprise entre des couches internes stratifiées isolantes et/ou conductrices ;
- une fixation mécanique, par l'intermédiaire de portions diélectriques de préimprégné de résine (PP1_{H}, PP2_{H}, PP3_{H}, PP4_{H} ; PP1_{L}, PP2_{L}, PP3_{L}), de tronçons de bus barre en métal (BB1_{H}, BB2_{H}, BB3_{H}, BB4_{H} ; BB1_{L}, BB2_{L}, BB3_{L}) à des emplacements espacés prédéterminés sur des faces opposées haute et basse de ladite ébauche (EB1) ; et
- pour chacune desdites faces opposées haute et basse, une interconnexion par dépôt de couche de métal (ME_{H}, ME_{L}) desdits tronçons de bus barre (BB1_{H}, BB2_{H}, BB3_{H}, BB4_{H} ; BB1_{L}, BB2_{L}, BB3_{L}) fixés sur la face considérée et d'une face de contact de ladite puce électronique (MT, MD), formant ainsi ledit circuit électronique de puissance comportant des bus barres (BB_{H}, BB_{L}) formant dissipateurs thermiques.

10. Procédé selon la revendication 9, **caractérisé en ce qu'**il comporte des étapes de stratification, de retrait de matière par ablation, d'électrodéposition et de photolithographie.

## Patentansprüche

1. Elektronische Leistungsschaltung, umfassend mindestens einen Mikrochip (MT, MD), ein stratifiziertes Substrat (LA1, LA2, SB), das aus isolierenden und leitenden Schichten gebildet ist, und Kühlmittel, wobei der Mikrochip im Substrat eingesetzt ist und die Kühlmittel an einer ersten und zweiten, gegenüberliegenden Seite des Substrats befestigt sind, wobei die Kühlmittel eine erste und zweite Stromschiene umfassen, die Kühlkörper (BBH, BBL) bilden und jeweils an der ersten und zweiten, gegenüberliegenden Seite des Substrats befestigt sind, **dadurch gekennzeichnet, dass** die erste und zweite Stromschiene (BBH, BBL) jeweils aus einer Vielzahl von Stromschienenabschnitten aus Metall (BB1H, BB2H, BB3H, BB4H; BB1L, BB2L, BB3L) gebildet sind, die an vorbestimmten beabstandeten Stellen (MCH,PE, MCL) befestigt sind und untereinander und mit einer Kontaktseite des Mikrochips (MT, MD) über eine Metallschicht (MEH, MEL) verbunden sind.

2. Elektronische Leistungsschaltung nach Anspruch 1, **dadurch gekennzeichnet, dass** die Stromschienenabschnitte (BB1_{H}, BB2_{H}, BB3_{H}, BB4_{H}; BB1_{L}, BB2_{L}, BB3_{L}) an der ersten und zweiten, gegenüberliegenden Seite des Substrats durch dielektrische Schichten (PP1_{H}, PP2_{H}, PP3_{H}, PP4_{H}; PP1_{L}, PP2_{L}, PP3_{L}) hindurch befestigt sind.

3. Elektronische Leistungsschaltung nach Anspruch 1 oder 2, **dadurch gekennzeichnet, dass** mindestens einer (BB2_{H}) der Stromschienenabschnitte an einer Elektrode (PE) des Mikrochips (MT) durch eine dielektrische Schicht (PP2_{H}) hindurch befestigt ist.

4. Elektronische Leistungsschaltung nach einem der Ansprüche 1 bis 3, **dadurch gekennzeichnet, dass** die Stromschienenabschnitte (BB1_{H}, BB2_{H}, BB3_{H}, BB4_{H}; BB1_{L}, BB2_{L}, BB3_{L}) und die leitenden Schichten (FC1, FC2, PL) und Metallschichten (ME_{H}, ME_{L}) aus Kupfer sind.

5. Elektronische Leistungsvorrichtung, **dadurch gekennzeichnet, dass** sie mindestens zwei Schaltungen nach einem der Ansprüche 1 bis 4 umfasst, wobei eine erste, als obere bezeichnete Schaltung (BC_{HS}) auf einer zweiten, als untere bezeichnete Schaltung (BC_{LS}) gestapelt ist, wobei die obere und untere Schaltung (BC_{HS}, BC_{LS}) mechanisch und elektrisch über ihre jeweiligen Stromschienen (BB_{H}, BB_{L}) verbunden sind, und dadurch, dass sie mindestens einen mittleren Raum zum Zirkulieren von Kühlflüssigkeit (CC₁, CC₂) umfasst, der zwischen der oberen und unteren Schaltung (BC_{HS}, BC_{LS}) liegt, wobei der mittlere Raum zum Zirkulieren von Kühlflüssigkeit (CC₁, CC₂) zwischen Abschnitten (BB1_{H}, BB2_{H}, BB3_{H}, BB4_{H}; BB1_{L}, BB2_{L}, BB3_{L}) der Stromschienen (BB_{H}, BB_{L}) gebildet ist.

6. Elektronische Leistungsvorrichtung nach Anspruch 5, **dadurch gekennzeichnet, dass** sie auch mindestens einen oberen Raum zum Zirkulieren von Kühlflüssigkeit (CHa₁, CHb₁, CHb₂) umfasst, der in einem oberen Teil der Vorrichtung (EM) liegt, wobei der obere Raum zum Zirkulieren von Kühlflüssigkeit (CHa₁, CHb₁, CHb₂) zwischen Abschnitten (BB1_{H}, BB2_{H}, BB3_{H}, BB4_{H}) einer oberen Stromschiene (BB_{H}) der oberen Schaltung (BC_{HS}) und einer oberen dielektrischen Schicht (DL_{HS}) gebildet ist.

7. Elektronische Leistungsvorrichtung nach Anspruch 5 oder 6, **dadurch gekennzeichnet, dass** sie auch mindestens einen unteren Raum zum Zirkulieren von Kühlflüssigkeit (CL₁, CL₂) umfasst, der in einem unteren Teil der Vorrichtung (EM) liegt, wobei der untere Raum zum Zirkulieren von Kühlflüssigkeit (CL₁, CL₂) zwischen Abschnitten (BB1_{L}, BB2_{L}, BB3_{L}) einer unteren Stromschiene (BB_{L}) der unteren Schaltung (BC_{LS}) und einer unteren dielektrischen Schicht (DL_{LS}) gebildet ist.

8. Elektronische Leistungsvorrichtung nach einem der Ansprüche 5 bis 7, **dadurch gekennzeichnet, dass** sie mindestens eine Steuerschaltung (CTRL_{HS}, CTRL_{LS}) umfasst, die an einem oberen Teil oder einem unteren Teil der Vorrichtung (EM) durch eine dielektrische Schicht (DL_{HS}, DL_{LS}) hindurch befestigt ist.

9. Verfahren zum Integrieren von Leistungsmikrochips und von Stromschienen, die Kühlmittel bilden, zur Herstellung einer elektronischen Leistungsschaltung nach einem der Ansprüche 1 bis 4, **dadurch gekennzeichnet, dass** es umfasst:
- eine Herstellung eines Rohlings (EB1), der mindestens einen Mikrochip (MT, M D) integriert, der zwischen den isolierenden und/oder leitenden stratifizierten inneren Schichten umfasst ist;
- ein mechanisches Befestigen, mit Hilfe von dielektrischen Stücken von Prepreg aus Harz (PP1_{H}, PP2_{H}, PP3_{H}, PP4_{H}; PP1_{L}, PP2_{L}, PP3_{L}), von Stromschienenabschnitten aus Metall (BB1_{H}, BB2_{H}, BB3_{H}, BB4_{H}; BB1_{L}, BB2_{L}, BB3_{L}) an vorbestimmten beabstandeten Stellen an einer gegenüberliegenden oberen und unteren Seite des Rohlings (EB1); und
- für jede der gegenüberliegenden oberen und unteren Seite, eine Vernetzung durch Metallschichtablagerung (ME_{H}, ME_{L}) der Stromschienenabschnitte (BB1_{H}, BB2_{H}, BB3_{H}, BB4_{H}; BB1_{L}, BB2_{L}, BB3_{L}), die an der betrachteten Seite befestigt sind, und einer Kontaktseite des Mikrochips (MT, MD), wodurch die elektronische Leistungsschaltung gebildet wird, die Stromschienen (BB_{H}, BB_{L}) umfasst, die Kühlkörper bilden.

10. Verfahren nach Anspruch 9, **dadurch gekennzeichnet, dass** es Schritte des Stratifizierens, der Materialentnahme durch Ablation, des Galvanisierens und der Photolithographie umfasst.

## Claims

1. Electronic power circuit comprising at least one electronic chip (MT, MD), a laminated substrate (LA1, LA2, SB) formed from insulating and conductive layers and heat dissipation means, said electronic chip being located in said substrate and said heat dissipation means being attached to first and second opposite faces of said substrate, said heat dissipation means comprising first and second busbars forming heat sinks (BBH, BBL) and mounted respectively on said first and second opposite faces of said substrate, **characterised in that** said first and second busbars (BBH, BBL) are each formed from a plurality of metal busbar sections (BB1H, BB2H, BB3H, BB4H; BB1L, BB2L, BB3L) attached to predetermined positions (MCH, PE, MCL) that are spaced apart and interconnected to one another and to a contact face of said electronic chip (MT, MD) by a metal layer (MEH, MEL).

2. Electronic power circuit according to claim 1, **characterised in that** said busbar sections (BB1_{H}, BB2_{H}, BB3_{H}, BB4_{H}; BB1_{L}, BB2_{L}, BB3_{L}) are attached to said first and second opposite faces of said substrate through dielectric layers (PP1_{H}, PP2_{H}, PP3_{H}, PP4_{H}; PP1_{L}, PP2_{L}, PP3_{L}).

3. Electronic power circuit according to claims 1 or 2, **characterised in that** at least one (BB2ₕ) of said busbar sections is attached to an electrode (PE) of said chip (MT) through a dielectric layer (PP2_{H}).

4. Electronic power circuit according to any one of claims 1 to 3, **characterised in that** said busbar sections (BB1_{H}, BB2_{H}, BB3_{H}, BB4_{H}; BB1_{L}, BB2_{L}, BB3_{L}) and said conductive layers (FC1, FC2, PL) and metal layers (ME_{H}, ME_{L}) are made of copper.

5. Electronic power device, **characterised in that** it comprises at least two circuits according to any one of claims 1 to 4, where a first said circuit called top (BC_{HS}) is stacked on a second circuit called bottom (BC_{LS}), where said top and bottom circuits (BC_{HS}, BC_{LS}) are mechanically and electrically coupled by the respective busbars thereof (BB_{H}, BB_{L}), and **in that** it comprises at least one central space for circulation of liquid coolant (CC₁, CC₂) located between said top and bottom circuits (BC_{HS}, BC_{LS}), where said central space for circulation of liquid coolant (CC₁, CQ₂) is formed between sections (BB1_{H}, BB2_{H}, BB3_{H}, BB4_{H}; BB1_{L}, BB2_{L}, BB3_{L}) of said busbars (BB_{H}, BB_{L}).

6. Electronic power device according to claim 5, **characterised in that** it also comprises at least one top space for circulation of liquid coolant (CHa₁, CHb₁, CH₂) located in the top part of the device (EM), where said top space for circulation of liquid coolant (CHa₁, CHb₁, CH₂) is formed between sections (BB1_{H}, BB2_{H}, BB3_{H}, BB4_{H}) of a top busbar (BB_{H}) of said top circuit (BC_{HS}) and a top dielectric layer (DL_{HS}).

7. Electronic power device according to claim 5 or 6, **characterised in that** it also comprises at least one bottom space for circulation of liquid coolant (CL₁, CL₂) which is located in a bottom part of the device (EM), where said bottom space for circulation of liquid coolant (CL₁, CL₂) is formed between sections (BB1_{L}, BB2_{L}, BB3_{L}) of a busbar (BB_{L}) of said bottom circuit (BC_{LS}) and a bottom dielectric layer (DL_{LS}).

8. Electronic power device according to any one of claims 5 to 7, **characterised in that** it comprises at least one control circuit (CTRL_{HS}, CTRL_{LS}) attached to a top part or a bottom part of the device (EM) through a dielectric layer (DL_{HS}, DL_{LS}).

9. Method of integrating electronic power chips and busbars forming heat sinks for the production of an electronic power circuit according to any one of claims 1 to 4, **characterized in that** it comprises:
- a formation of a blank (EB1) incorporating at least one electronic chip (MT, M D) included between two internal insulating and/or conductive laminated layers;
- a mechanical attachment (by means of resin-impregnated dielectric portions (PP1_{H}, PP2_{H}, PP3_{H}, PP4_{H}; PP1_{L}, PP2_{L}, PP3_{L}) of metal busbar sections (BB1_{H}, BB2_{H}, BB3_{H}, BB4_{H}; BB1_{L}, BB2_{L}, BB3_{L}) at predetermined spaced-apart positions on opposite top and bottom faces of said blank (EB1); and
- for each of said opposite top and bottom faces, an interconnection by metal layer deposition (ME_{H}, ME_{L}) of said busbar sections (BB1_{H}, BB2_{H}, BB3_{H}, BB4_{H}; BB1_{L}, BB2_{L}, BB3_{L}) attached to the face concerned and of a contact face of said electronic chip (MT, MD), thus forming said electronic power circuit comprising busbars (BB_{H}, BB_{L}) forming heat sinks.

10. Method according to claim 9, **characterised in that** it comprises steps of lamination, removal of material by ablation, electrodeposition and photolithography.
